# EUROPEAN PATENT SPECIFICATION

(11) **EP 0 988 702 B1**
(45) Date of publication and mention of the grant of the patent: **03.04.2002**
(21) Application number: 98925658.1
(22) Date of filing: 09.06.1998
(51) Int. Cl.: H03K 17/08

(54) **TRANSIENT PROTECTION**
ÜBERGANGSSCHUTZ
PROTECTION TRANSITOIRE

(30) Priority: 10.06.1997 FI 972456
(43) Date of publication of application: 29.03.2000
(73) Proprietor: Oy Lexel Finland AB, 02200 Espoo (FI)
(72) Inventor: SAIRANEN, Martti, FIN-01800 Klaukkala (FI); KAIJÄRVI, Mikko, FIN-00350 Helsinki (FI)
(74) Representative: Tanhua, Pekka Vilhelm
(86) International application number: FI9800494
(87) International publication number: WO9859420

(56) References cited:
- EP-A- 0 528 668
- DE-A- 3 712 784
- DE-A- 19 548 612
- JP-A- 8 321 756
- IEEE TRANSACTIONS ON ELECTRON DEVICES, Volume 38, No. 7, July 1991, T. MATSUSHITA et al., "A Surge-Free Intelligent Power Device Specific to Automotive High Side Switches", pages 1576-1580.
- IEEE TRANSACTIONS ON INDUSTRY APPLICATIONS, Volume 33, No. 6, November 1997, RAHUL S. CHOKHAWALA et al., "Switching Voltage Transient Protection Schemes for High-Current IGBT MODULES".

## Description

The present invention relates to a transient protection, especially to a method for protecting a field effect transistor unit from a transient surge according to the preamble of claim 1. The present invention also relates to a circuit for protecting a field effect transistor unit from a transient surge according to the preamble of claim 2.

A transient surge is an overvoltage and/or overcurrent surge, the peak value of which can exceed 500 volts and/or 200 amperes, and in worst case a transient surge can last for several microseconds. The high energy content of such a transient surge can easily destroy a field effect transistor.

The problem mentioned above is especially common in field effect transistors used as switches in dimmer solutions. In these cases the mains voltage or other AC voltage is connected to one side of the field effect transistor unit and the load is correspondingly connected to the other side of the unit. In this respect, reference is made to for example the Finnish patent application 945095. The load current flows in the channel between the collector (drain) and the emitter (source) of one or more field effect transistors, with the channel being sequentially switched to conducting/non-conducting (i.e. open/closed) states during the half-cycle of AC voltage by means of a voltage arranged to the gate of the field effect transistor. Such transient surges can occasionally reach the dimmer from the mains. Turning off a fluorescent lamp can also cause voltage surges. Transient surges of sufficient magnitude can destroy the field effect transistor unit.

Field effect transistors (FET) are currently commonly used in various switching solutions. Usually a field effect transistor comprises a large number of small field effect transistor elements (chips) processed on a single semi-conductor chip, arranged so as to operate together in parallel. With this arrangement, the switching properties and current capacity of a field effect transistor have been considerably improved over the previous single-element field effect transistors.

A problem with these field effect transistors are nevertheless sudden, powerful transient surges, which can destroy the transistor, if they occur over the transistor while it is in closed state (i.e. non-conducting state). Basically, the destruction process starts with an avalanche breakdown in one of the field effect transistor elements, from which it spreads to other elements. Thus, it is this spot-like place of the field effect transistor that is destroyed, after which the field effect transistor fails to operate correctly.

There are previously known components and circuit solutions for protecting an electronic circuit or component against transient surges. One of these protective components is a transient absorbing zener (TAZ), which is connected over the circuit or component to be protected. There nevertheless remains the problem that the characteristic voltage curve of such a zener diode rises relatively slowly, whereby the zener diode does not have the time to react to a fast transient surge. This means that the TAZ does not work as intended, especially in connection with a field effect transistor. The field effect transistor is destroyed before the zener diode is conductive and allows the transient surge to flow through the diode.

The purpose of the present invention is to disclose a new, improved method of protecting a field effect transistor from a transient surge, especially in a switching solution. The above-mentioned problems can be solved by means of the present invention.

The characterizing features of a method according to the invention are disclosed in the characterizing part of claim 1. The characterizing features of a circuit according to the invention are disclosed in the characterizing part of claim 2. Further, preferable embodiments of the invention are disclosed in the dependent claims.

An advantage of the invention is that transient protection of a field effect transistor unit can be carried out simply and effectively. The present invention enables a field effect transistor unit to be protected reliably against transient surges so that a transient surge does not destroy the field effect transistor switch used in for example dimmer solutions. The protection according to the invention enables a field effect transistor unit to withstand hundreds, even thousands of occasional transient surges.

An advantage of the circuit according to the invention is that it only requires a few additional electronic components. A further advantage is that the protection circuit can be arranged in a small space, for which reason it is suitable for use with especially field effect transistors arranged as electric AC power controls in a dimmer.

In the following, the invention is described in more detail with reference to the appended drawings, of which
- figure 1: is a block diagram of a circuit arranged in a dimmer according to the invention for protecting a field effect transistor unit from a transient surge;
- figure 2a: is an illustration of a transient surge in rectified mains voltage;
- figure 2b: is an illustration of the wave form of a dimmer load voltage;
- figure 3: illustrates a circuit for protecting a pair of field effect transistors from transient surges, the circuit being arranged in a dimmer;
- figure 4: illustrates another circuit arranged in a dimmer for protecting a field effect transistor pair from a transient surge, the circuit also having a short circuit protection circuit; and
- figure 5: illustrates the voltage waveforms in a circuit according to figure 4.

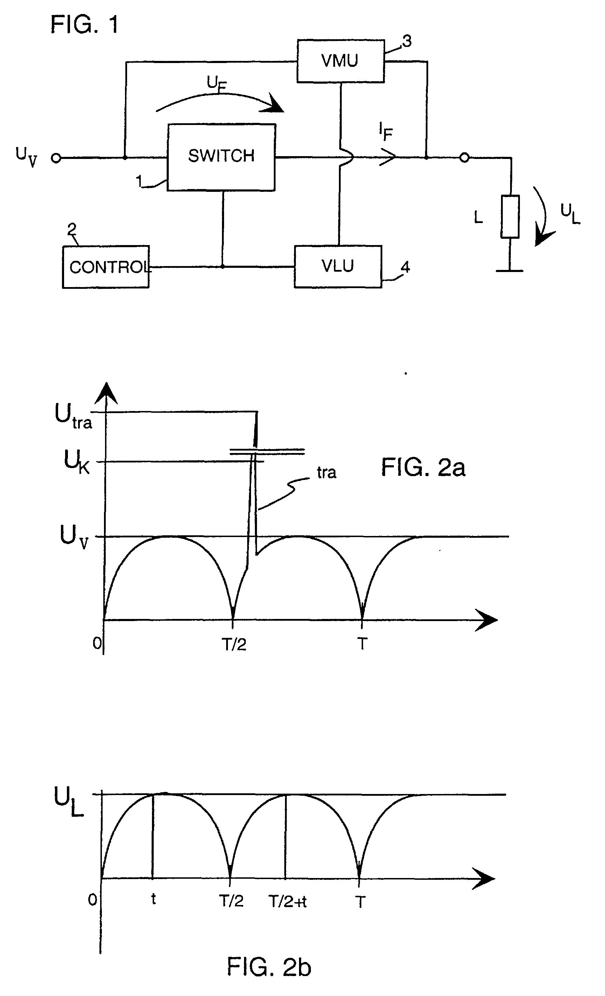

Figure 1 is a block diagram illustration of a circuit according to the invention for protecting a field effect transistor unit, especially a field effect transistors unit acting as a switch, from transient surge. In this case, the transient surge protection is arranged in connection with the dimmer used as a lighting control unit. The switch 1 comprises one or more field effect transistors. Rectified alternating voltage U_{V}, fig. 2a, is fed via switch 1 to lighting load L from the mains or other AC power source. The switch 1 is used for controlling the AC power of the load L. The load L is connected to mains at moment t (from the start of the half-cycle) of half-cycle T/2 of mains voltage U_{V} by means of the control unit 2 of the switch 1, so that electrical power output to the load L is increased by advancing the moment t, i.e. bringing it closer to the start of the half-cycle. Accordingly, the load L is disconnected from the mains when t is at the end of the half-cycle, when the mains voltage is 0. Figure 2b illustrates the wave form of the voltage U_{L} over the load L. Thus the switch 1 is in non-conducting state during intervals 0, t and T/2, T/2+ t, with the switch correspondingly in conducting state for the remainder of the half-cycles, i.e. intervals t, T/2 and T/2+t, T.

If there is a transient surge in the mains voltage U_{V} during the time the field effect transistor switch 1 is in non-conducting state (i.e. during intervals 0, t and T/2, T/2+t), the surge will destroy the switch 1. To prevent this, the circuit of figure 1 is provided with a transient protection circuit according to the invention. The protection circuit comprises a voltage monitoring unit 3 for monitoring the voltage U_{F} over the field effect transistor 1 and for noticing the rapidly increasing transient surge (figure 2a), a voltage lowering unit 4 for lowering the rapidly increasing transient surge Uₜᵣₐ and arranging it to act as field effect transistor control voltage U_{go}. This control voltage is used for switching the field effect transistor into at least partially conducting state following the transient surge. When the transient surge increases the voltage U_{F} over the field effect transistor switch 1 over a preset threshold value U_{K}, the field effect transistor switch 1 is switched into conducting state, whereby the transient surge is caused to flow through the field effect transistor switch 1. With this method, the voltage U_{F} over the field effect transistor 1 is limited and the current I_{F} over the switch is controlled. Thus the transient surge does not damage a field effect transistor or a number of field effect transistors of the switch 1, but a great proportion of the energy of the transient surge is caused to flow through the field effect transistors of the field effect transistor unit 1 in a controlled way. The threshold value U_{K} is defined according to the properties of the field effect transistors of the switching unit 1, mainly according to the voltage tolerance of the field effect transistors of the switching unit 1, as specified by the manufacturer.

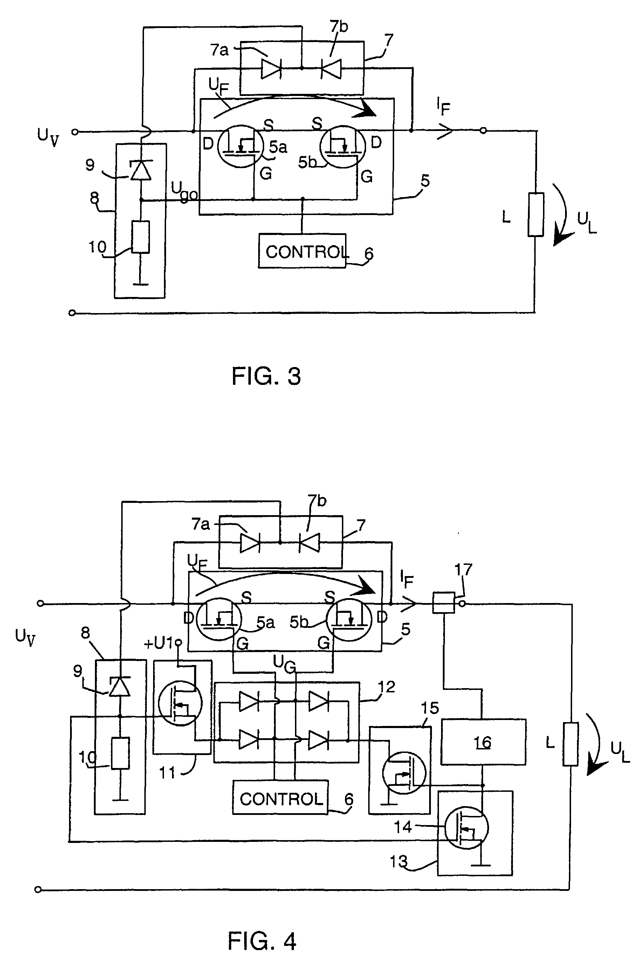

Figure 3 is an example of a preferable transient protection circuit according to the invention for protecting the field effect transistor unit 5 from a transient surge. In this case, the field effect transistor switch 5 comprises two field effect transistors 5a, 5b, the collector (D) and emitter (S) channels of which are connected in series in a previously known way. The usual switching control of the field effect transistor switch 5 is carried out by means of a control unit 6 by conducting the control signals to the bases of the field effect transistors 5a, 5b (see figures 2a, 2b). The mains voltage U_{V} or some other AC power source is connected to the input terminal of the field effect transistor 5 and the load L is correspondingly connected to the output terminal of the switch 5. The voltage monitoring unit 7 is arranged over the field effect transistor switch 5, from its input terminal to its output terminal, usually between the collectors (D) of field effect transistors 5a, 5b.

The voltage monitoring unit 7 in figure 3 comprises two diodes 7a, 7b connected in series so that they are conductive in opposite directions. The voltage U_{F} over the field effect transistor switch 5 is monitored from between the diodes 7a, 7b. In this solution, the voltage lowering unit 8 comprises a zener diode 9. The zener diode is connected between the terminal located between the diodes 7a, 7b of the monitoring unit 7 and the common base point G of the field effect transistors 5a, 5b of the field effect transistor switch 5. Additionally, the zener diode 9, together with the base point G of the field effect transistors 5a, 5b, is connected to earth by means of resistor 10.

The transient protection circuit as illustrated in figure 3 for protecting the field effect transistor pair 5a, 5b of the field effect transistor switch 5 functions as follows: When there is a strong transient surge in the mains voltage U coinciding with a half-cycle interval in which the field effect transistors 5a, 5b used as switches are in non-conducting state, the transient surge causes a strong voltage increase both over the switch 5 and in the voltage monitoring unit 7. This means that voltage Uₜᵣₐ (see figure 2a) in the intermediate point formed by the interconnected cathodes of diodes 7a, 7b increases rapidly and exceeds the preset threshold value U_{K}, for example 400 V. The voltage lowering unit 8, i.e. the zener diode 9 reacts and decreases the excessive voltage Uₜᵣₐ detected by the monitoring unit 7, preferably to about one hundredth of the original value, to a low voltage of for example 4 V. This zener diode 9 output voltage U_{go} is even suitable for directly controlling the field effect transistors 5a, 5b of the field effect transistor switch 5 so that both of the field effect transistors are switched into conducting state by this low voltage from the anode of the zener diode 9. The control voltage from the voltage lowering unit 8, in this case zener diode 9, is chosen so that when the transient surge exceeds a certain limit value, a control voltage, sufficient for opening both field effect transistor switches, is conducted to the bases of the field effect transistors 5a, 5b of the field effect transistor switch 5. In this solution, the threshold value U_{K} is set by choosing a suitable threshold voltage for the zener diode 9.

It is to be noted that the voltage monitoring unit 7 reacts very fast. The unit can follow rapid transient surges so that when a transient surge exceeds the voltage threshold value U_{K}, the field effect transistors 5a, 5b of the field effect transistor switch 5 can be immediately switched to conducting state by conducting a control pulse via the voltage lowering unit 8 to the bases G of the field effect transistors 5a, 5b. Thus, the energy of a transient surge can be conducted through the field effect transistor switch 5 without damaging field effect transistors, especially field effect transistor elements.

When field effect transistors are used as switches, it is preferable to arrange a short circuit protection unit with them. This is especially the case with dimmer applications. Figure 4 illustrates another circuit according to the invention for protecting the field effect transistor switching unit from transient surges. The circuit of figure 4 also comprises a short circuit protection unit.

In the application illustrated by figure 4 parts corresponding with the parts of figure 3 are referred to with the same numbers. The switch 5 comprises a field effect transistor pair 5a, 5b. In this application, the transient protection circuit comprises, in addition to the monitoring unit 7 and the voltage lowering unit 8, an amplifier 11, the input voltage of which is provided by the zener diode 9 of the voltage lowering unit 8. The amplifier 11 is further connected via diode bridge 12 to the common terminal G of the field effect transistors 5a, 5b of the field effect transistor switch 5.

The short circuit protection circuit comprises a short circuit protection switch 15, a control unit 16 for it and a load current measurement arrangement 17. The current measurement arrangement 17 is used for measuring the load current, and the control unit 16 is used for detecting a short circuit (a sudden strong increase of current to the load L that increases the preset current limit value). The short circuit protection switch 15 is opened on the basis of the short circuit information by the control unit 16. This in turn controls the control gate G of the field effect transistor switch 5 and closes the field effect transistor switch 5, whereby load L is disconnected from current. The short circuit protection switch 15 is in this application a field effect transistor. Diode bridge 12 is used for connecting the control effects of the transient protection and the short circuit protection to the control input G of the field effect transistor switch 5.

The transient protection circuit illustrated in figure 4 also comprises a control unit 13 for switching the short circuit protection off. This control unit 13 is controlled by the output voltage of the voltage lowering unit 8, i.e. the zener diode 9, which is the same voltage as is used as an input for the amplifier 11. In this application the control unit 13 comprises a switch, such as a field effect transistor 14, which is controlled by the low voltage from the zener diode 9 of the voltage lowering unit 8. The control unit 13 and the switching transistor 14 are in the illustrated application arranged in the control input of the short circuit protection switch 15, to which the output of the actual short circuit protection unit 16 is connected as well. The delay caused by the amplifier 11 is used for switching the short circuit protection off prior to switching the field effect transistor unit 5 into conducting state.

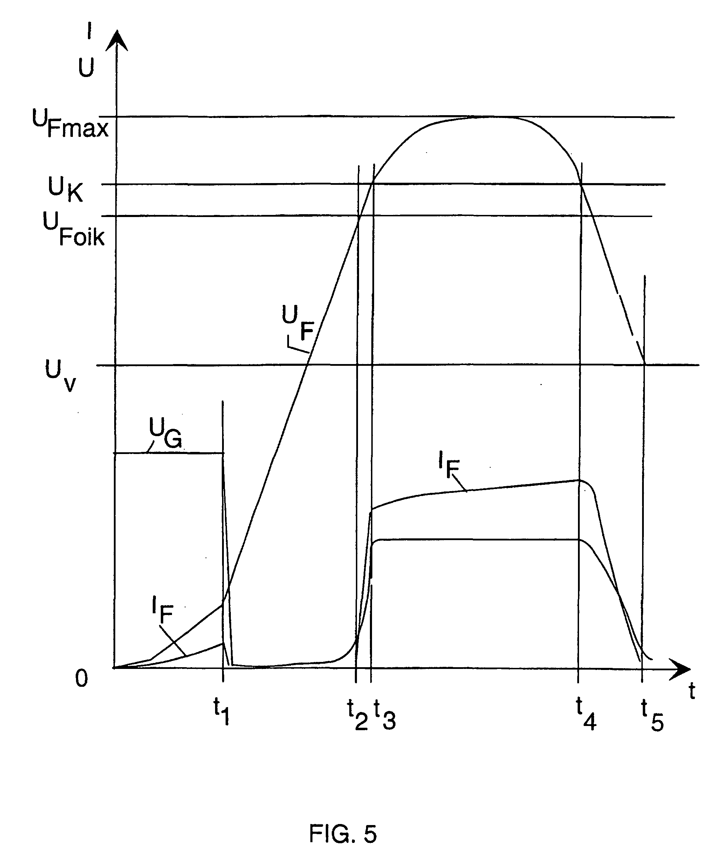

The operation of a circuit according to the invention during a transient surge is illustrated by the voltage and current curves of figure 5. The abbreviations used in figure 5 are as follows: The ordinate of the figure is U (voltage), with t (time) as the abscissa; U_{G} is the gate control voltage of the field effect transistor switch 5; U_{F} is the voltage over the field effect transistor switch 5 while I_{F} is the current through the field effect transistor switch 5. In the described example the field effect transistor switch 5 is in closed state during moment 0 (same phase as during the intervals T/2, T/2+t of figure 1). When there is a sudden transient surge, the voltage U_{F} over the field effect transistor switch 5 starts to increase as does the current I_{F}; the short circuit protection control unit 16 detects the current I_{F} exceeding the preset short circuit limit value at moment t₁ and switches the short circuit protection switch 15 to conducting state. This causes the gate control voltage U_{G} to decrease to near zero, and the field effect transistor switch 5 is switched to non-conducting state, whereby the current I_{F} through the field effect transistor switch 5 ceases. The transient surge nevertheless causes the voltage U_{F} to increase. When the voltage U_{F} reaches the preset limit value U_{Foik} (e.g. 400 V) at t₂, the output voltage of the voltage lowering unit 8, i.e. the zener diode 9 increases sufficiently to cause the control unit 13 to open the switch 14. As a result of this, the short circuit protection unit is eliminated: the control voltage of the switch 15 is decreased by for example earthing it, whereby the switch 15 is closed. The voltage U_{F} will still increase, and will at t₃ reach another limit value, the preset threshold value U_{K} (for example 450 V), which causes the field effect transistor switch 5 to be switched by the voltage lowering unit 8 and amplifier 11 to at least partially conducting state: the gate control voltage U_{G} increases to a low voltage of about 2-5 V. The current I_{F} through the field effect transistor switch 5 increases rapidly during interval t₂-t₃ because the short circuit protection has been eliminated. The increase of current nevertheless culminates near t₃, after which there is only a controlled, relatively constant current I_{F} through the field effect transistor switch 5. The voltage U_{F} increases simultaneously, but decelerating, as illustrated in figure 5, and it reaches a preset peak value U_{Fmax} of about 500 V, which corresponds to the peak value of the transient surge, but is noticeably smaller than the surge. After this, the voltage U_{F} starts to decrease. When the voltage U_{F} decreases below the limit value U_{Foik} at t₄, the output voltage of the voltage lowering unit 8, i.e. the zener diode 9, decreases to a value insufficient to control the control unit 13. Consequently the switch 14 is closed. This reactivates the short circuit current protection: the switch 15 gets its control voltage from the control unit 16, and the switch 15 is opened. The gate control voltage U_{G} drops to zero, and the switch 5 is switched to non-conducting state. The field effect transistor unit 5 remains in non-conducting state, and the voltage U_{F} does not return to a low voltage value, but remains to follow (at t₅) the input voltage, such as rectified mains voltage U_{V} of the switching unit 5.

In the above, the invention has been disclosed with reference to mainly one preferred embodiment, but it is evident, that many change can be made to invention within the scope of the invention as defined by the appended claims.

## Claims

1. A method of protecting a field effect transistor unit (1; 5), used as a switch, from a transient surge, where the voltage over the field effect transistor unit (1; 5) is monitored especially when the field effect transistor unit (1; 5) is in non-conducting state for detecting any transient surges (Uₜᵣₐ); **characterized in that** when the voltage (U_{F}) over the field effect transistor unit (1; 5) exceeds a preset threshold value (U_{K}), the field effect transistor unit (1; 5) is switched into at least partly conducting state following the transient surge (Uₜᵣₐ) so that the voltage (U_{F}) over the field effect transistor unit (1; 5) is limited and the current (1_{F}) is controlled and the transient surge (Uₜᵣₐ) is caused to flow through the field effect transistor unit (1; 5) without damaging it.

2. A circuit for protecting a field effect transistor unit, used as a switch, from a transient surge, which circuit comprises a voltage monitoring unit (3; 7) for monitoring the voltage (U_{F}) over the field effect transistor unit (1; 5) for detecting any transient surges (Uₜᵣₐ), **characterized in that** the circuit further comprises a voltage lowering unit (4; 8) for lowering the voltage caused by the transient surge (Uₜᵣₐ) to a control voltage (U_{go}) suitable for opening the field effect transistor unit (1; 5) to at least partly conducting state following the transient surge (Uₜᵣₐ) so that the voltage (U_{F}) over the field effect transistor unit (1; 5) is limited and the current (I_{F}) is controlled and the transient surge (Uₜᵣₐ) is caused to flow through the filed effect transistor unti (1; 5) without damaging it.

3. A circuit according to claim 2, **characterized in that** the voltage monitoring unit (7) comprises two diodes (7a, 7b) connected in series so that they are conductive in opposite directions, with the voltage over the field effect transistor unit (1; 5) being monitored between the diodes (7a, 7b).

4. A circuit according to claim 2 or 3, **characterized in that** the voltage lowering unit (8) comprises a zener diode (9).

5. A circuit according to claim 2 or 3, **characterized in that** the voltage lowering unit (8) comprises a zener diode (9) with a subsequent amplifier stage (11) for controlling the field effect transistor unit (5).

6. A circuit according to any of the claims 2 - 5, **characterized in that** the circuit comprises a control unit (13) for switching the short circuit protection unit (15, 16) off prior to switching the field effect transistor unit 5 to conducting state.

7. A circuit according to claim 6, **characterized in that** the control unit (13) comprises a switch, such as a field effect transistor (14), which is controlled by the output voltage of the voltage lowering unit (8), especially a zener diode (9).

## Patentansprüche

1. Verfahren zum Schutz einer als Schalter verwendeten Feldeffekttransistoreinheit (1; 5) gegen eine kurzzeitige Überspannung, wobei zur Ermittlung von kurzzeitigen Überspannungen (Uₜᵣₐ) die Spannung über der Feldeffekttransistoreinheit (1; 5) überwacht wird, insbesondere wenn sich die Feldeffekttransistoreinheit (1; 5) in einem nichtleitenden Zustand befindet; **dadurch gekennzeichnet, daß** wenn die Spannung (U_{F})über der Feldeffekttransistoreinheit (1; 5) einen voreingestellten Schwellenwert (U_{K}) übersteigt, die Feldeffekttransistoreinheit (1; 5) der kurzzeitigen Überspannung (Uₜᵣₐ)folgend in einen zumindest teilweise leitenden Zustand geschaltet wird, so daß die Spannung (U_{F}) über der Feldeffekttransistoreinheit (1; 5) begrenzt und der Strom (I_{F}) gesteuert und die kurzzeitige Überspannung (Uₜᵣₐ) veranlaßt wird, durch die Feldeffekttransistoreinheit (1; 5) zu fließen, ohne sie zu beschädigen.

2. Schaltung zum Schutz einer als Schalter verwendeten Feldeffekttransistoreinheit gegen eine kurzzeitige Überspannung, welche Schaltung zur Ermittlung von kurzzeitige Überspannungen (Uₜᵣₐ) eine Spannungsüberwachungseinheit (3; 7) zur Überwachung der Spannung (U_{F}) über der Feldeffekttransistoreinheit (1; 5) enthält, **dadurch gekennzeichnet, daß** die Schaltung des weiteren eine Spannungssenkungseinheit (4; 8) zur Senkung der durch die kurzzeitige Überspannung (Uₜᵣₐ) verursachten Spannung auf eine Steuerspannung (U_{go}) enthält, die geeignet ist, die Feldeffekttransistoreinheit (1; 5) der kurzzeitigen Überspannung (Uₜᵣₐ) folgend in einen zumindest teilweise leitenden Zustand zu öffnen, so daß die Spannung (U_{F}) über der Feldeffekttransistoreinheit (1; 5) begrenzt und der Strom (1_{F}) gesteuert und die kurzzeitige Überspannung (Uₜᵣₐ) veranlaßt wird, durch die Feldeffekttransistoreinheit (1; 5) zu fließen, ohne sie zu beschädigen.

3. Schaltung gemäß Anspruch 2, **dadurch gekennzeichnet, daß** die Spannungsüberwachungseinheit (7) zwei derart in Reihe geschaltete Dioden (7a; 7b) enthält, daß sie in entgegengesetzten Richtungen leitend sind und die Spannung über der Feldeffekttransistoreinheit (1; 5) zwischen den Dioden (7a; 7b) überwacht wird.

4. Schaltung gemäß Anspruch 2 oder 3, **dadurch gekennzeichnet, daß** die Spannungssenkungseinheit (8) eine Zenerdiode (9) enthält.

5. Schaltung gemäß Anspruch 2 oder 3, **dadurch gekennzeichnet, daß** die Spannungssenkungseinheit (8) zur Steuerung der Feldeffekttransistoreinheit (5) eine Zenerdiode (9) mit einer nachfolgenden Verstärkerstufe (11) enthält.

6. Schaltung gemäß einem der Ansprüche 2 - 5, **dadurch gekennzeichnet, daß** die Schaltung eine Steuereinheit (13) zum Abschalten der Kurzschlußschutzeinheit (15, 16) vor dem Schalten der Feldeffekttransistoreinheit (5) in einen leitenden Zustand enthält.

7. Schaltung gemäß Anspruch 6, **dadurch gekennzeichnet, daß** die Steuereinheit (13) einen Schalter wie etwa einen Feldeffekttransistor (14) enthält, der durch die Ausgangsspannung der Spannungssenkungseinheit (8), insbesondere einer Zenerdiode (9), gesteuert wird.

## Revendications

1. Procédé de protection d'une unité de transistors à effet de champ (1 ; 5) utilisée comme commutateur, contre une surtension transitoire, dans lequel la tension aux bornes de l'unité de transistors à effet de champ (1 ; 5) est commandée spécialement lorsque l'unité de transistors à effet de champ (1 ; 5) est à l'état non passant pour détecter toute surtension transitoire (Uₜᵣₐ) ; **caractérisé par le fait que** lorsque la tension aux bornes de l'unité de transistors à effet de champ (1 ; 5) excède une valeur de seuil (Uₖ) prédéterminée, l'unité de transistors à effet de champ (1 ; 5) est commutée dans un état au moins partiellement conducteur à la suite de la surtension transitoire (Uₜᵣₐ), de sorte que la tension (U_{F}) aux bornes de l'unité de transistors à effet de champ (1 ; 5) est limitée et le courant (I_{F}) est contrôlé et que la surtension transitoire (Uₜᵣₐ) est forcée à passer à travers l'unité de transistors à effet de champ (1 ; 5) sans l'endommager.

2. Circuit de protection d'une unité de transistors à effet de champ, utilisée comme commutateur contre une surtension transitoire, ledit circuit comprenant une unité de commande de la tension (3 ; 7) pour commander la tension (U_{F}) aux bornes de l'unité de transistors à effet de champ (1; 5) pour détecter toute surtension transitoire (Uₜᵣₐ), **caractérisé par le fait que** le circuit comporte en outre une unité chutrice de tension (4, 8) pour abaisser la tension provoquée par la surtension transitoire (Uₜᵣₐ) à une tension de commande (U_{go}) adaptée pour ouvrir l'unité de transistors à effet de champ (1 ; 5) en un état partiellement conducteur suite à la surtension transitoire (Uₜᵣₐ) de sorte que la tension (U_{F}) aux bornes de l'unité de transistors à effet de champ (1 ; 5) soit limitée et le courant (I_{F}) soit contrôlé et que la surtension transitoire (Uₜᵣₐ) soit forcée de passer à travers l'unité de transistors à effet de champ (1 ; 5) sans l'endommager.

3. Circuit selon la revendication 2, **caractérisé par le fait que** l'unité (7) de commande de la tension comporte deux diodes (7a, 7b) connectées en série de façon qu'elles soient conductrices en sens opposé, et la tension aux bornes de l'unité de transistors à effet de champ (1; 5) soit commandée entre les diodes (7a, 7b).

4. Circuit selon la revendication 2 ou 3, **caractérisé par le fait que** l'unité chutrice de tension (8) comporte une diode Zener (9).

5. Circuit selon la revendication 2 ou 3 **caractérisé par le fait que** l'unité chutrice de tension 8 comporte une diode Zener (9) avec un étage d'amplification (11) en aval pour commander l'unité de transistors à effet de champ (5).

6. Circuit selon l'une quelconque des revendications 2 à 5, **caractérisé par le fait que** le circuit comporte une unité de commande (13) pour décommuter l'unité de court-circuit (15, 16) avant de commuter l'unité de transistors à effet de champ 5 sur l'état conducteur.

7. Circuit selon la revendication 6, **caractérisé par le fait que** l'unité de commande (13) comprend un commutateur tel qu'un transistor à effet de champ (14), qui est commandé par la tension de sortie de l'unité chutrice de tension (8), spécialement une diode Zener (9).
